# EUROPÄISCHE PATENTSCHRIFT

(11) **EP 1 587 138 B1**
(45) Veröffentlichungstag und Bekanntmachung des Hinweises auf die Patenterteilung: **30.05.2007**
(21) Anmeldenummer: 04106169.8
(22) Anmeldetag: 29.11.2004
(51) Int. Cl.: H01L 21/68, H01L 21/00

(54) **Einrichtung für die Montage von Halbleiterchips und Verfahren zum Ablösen eines Halbleiterchips von einer Folie**
Apparatus for mounting of semi-conductor chips and method for stripping of a semi-conductor chip from a film
Dispositif pour la montage de de puces semiconductrices et procédé de séparer de puces semiconductries d'une feuille

(30) Priorität: 13.04.2004 EP 04101498; 29.06.2004 EP 04103054
(43) Veröffentlichungstag der Anmeldung: 19.10.2005
(73) Patentinhaber: Oerlikon Assembly Equipment AG, Steinhausen, 6330 Cham (CH)
(72) Erfinder: Medding, Jonathan, 5413, Birmensdorf (CH); Stalder, Roland, 8050, Zuerich (CH); Lustenberger, Martina, 6332 Hagendorn (CH); Niederhauser, Marcel, 6312, Steinhausen (CH); Schnetzler, Daniel, 6314, Unteraegeri (CH)
(74) Vertreter: Falk, Urs

(56) Entgegenhaltungen:
- US-B1- 6 561 743

## Beschreibung

Die Erfindung betrifft ein Verfahren zum Ablösen eines Halbleiterchips von einer Folie der im Oberbegriff des Anspruchs 1 genannten Art und eine für die Durchführung des Verfahrens geeignete Einrichtung für die Montage von Halbleiterchips.

Die Halbleiterchips werden typischerweise auf einer von einem Rahmen gehaltenen Folie, in der Fachwelt auch als Tape bekannt, zur Abarbeitung mit einer solchen Montage-Einrichtung bereitgestellt. Die Halbleiterchips haften auf der Folie. Der Rahmen mit der Folie wird von einem verschiebbaren Wafertisch aufgenommen. Taktweise werden der Wafertisch sich verschoben, so dass ein Halbleiterchip nach dem anderen an einem ersten Ort A bereitgestellt wird, und dann der bereitgestellte Halbleiterchip von einem Chipgreifer aufgenommen und an einem zweiten Ort B auf einem Substrat plaziert. Die Entnahme des bereitgestellten Halbleiterchips von der Folie wird von einem unterhalb der Folie angeordneten Chip-Auswerfer (in der Fachwelt bekannt als Die-Ejector) unterstützt. Dabei unterstützt in der Regel mindestens eine im Chip-Auswerfer angeordnete Nadel das Ablösen des Halbleiterchips von der Folie.

Aus dem Patent US 4 921 564 ist ein Verfahren bekannt geworden, bei dem die Halbleiterchips ohne Hilfe einer Nadel von der Folie abgelöst und vom Chipgreifer aufgenommen werden können. Bei diesem Verfahren wird die Folie mit den Halbleiterchips auf einer heizbaren Platte plaziert. Die Platte weist auf der der Folie zugewandten Seite mit Vakuum beaufschlagbare Vertiefungen auf. Bei der Montage werden einerseits die Vertiefungen mit Vakuum beaufschlagt, so dass die Folie in die Vertiefungen gezogen wird und sich stellenweise von den Halbleiterchips löst. Um die Haftung der Halbleiterchips an der Folie zusätzlich zu verkleinern, wird die Folie andererseits auf eine Temperatur von 50° C bis 65°C aufgeheizt. Dieses Verfahren funktioniert für eine Vielzahl von Halbleiterchips, bei vergleichsweise grossen, aber sehr dünnen Halbleiterchips kommt es jedoch oft vor, dass sich einige der Halbleiterchips beim Anlegen des Vakuums und Abziehen der Folie aufstellen und nachher auf die Folie zurückfallen, wobei es auch zu Überlappungen benachbarter Halbleiterchips kommt.

Die Dicke der abzulösenden Halbleiterchips nimmt laufend ab. Heutzutage beträgt die Dicke in vielen Fällen bereits nur noch 100 Mikrometer, mit der Tendenz zu weiter reduzierten Dicken von 75 bis 50 Mikrometer. Dazu kommt, dass die Wafer auf ihrer Rückseite mit einer Klebschicht versehen sind. Die Haftung der Halbleiterchips auf der Folie vergrössert sich deswegen. Die oben beschriebene Technologie, bei der die Halbleiterchips mit der Hilfe von Nadeln abgelöst werden, kommt an ihre Grenze. Auch das Ablösen der Folie mit Vakuum gemäss der US 4 921 564 funktioniert nicht mehr: Die Folie kann nicht mehr auf die erforderliche Temperatur von 50° C bis 65°C aufgeheizt werden, da die Klebschicht bei diesen Temperaturen bereits aushärtet, so dass der Halbleiterchip noch besser auf der Folie haftet.

Ein Verfahren der im Oberbegriff des Anspruchs 1 genannten Art ist aus dem Patent US 6 561 743 bekannt. Bei diesem Verfahren wird die Folie mit dem abzulösenden Halbleiterchip über eine Kante gezogen, wobei sich Halbleiterchip und Folie an der Kante voneinander lösen. Das Ablösen der Folie wird gestoppt, bevor sich der Halbleiterchip vollständig von der Folie gelöst hat. Damit sich der Halbleiterchip kontrolliert von der Folie löst, wird vorgängig der Chipgreifer auf den Halbleiterchip abgesenkt und Vakuum an den Halbleiterchip angelegt. Anschliessend wird die Folie über die Kante gezogen, bis sich der Halbleiterchip vollständig von der Folie gelöst hat. Ein ähnliches Verfahren ist aus der Patentanmeldung US 2002129899 bekannt. Diese Verfahren haben den Nachteil, dass benachbarte Halbleiterchips beschädigt werden können, weil die zum Ablösen erforderliche Höhe der Kante etwa 1.5 Millimeter betragen muss.

Der Erfindung liegt die Aufgabe zugrunde, ein robustes Verfahren für das Ablösen der Halbleiterchips von einer Folie zu entwickeln, bei dem benachbarte Halbleiterchips nicht beschädigt werden.

Die Erfindung ist in den Ansprüchen 1 und 6 gekennzeichnet. Vorteilhafte Ausgestaltungen ergeben sich aus den abhängigen Ansprüchen.

Eine erfindungsgemässe Einrichtung für die Montage von dünnen Halbleiterchips, die auf einer Folie haften, umfasst einen Wafertisch, der die Folie mit den Halbleiterchips aufnimmt, und einen Chip-Auswerfer, dessen der Folie zugewandte Oberfläche eine der Breite der abzulösenden Halbleiterchips entsprechende Rampe mit einer Ablösekante aufweist, an der der Halbleiterchip von der Folie abgelöst wird. Die Oberfläche der Rampe ist konkav ausgebildet und erreicht an der Ablösekante eine maximale Höhe von nur etwa 0.3 Millimeter. Bevorzugt ist die Oberfläche eine zylindrische Fläche, da diese eine konstante Krümmung aufweist. Durch diese Form der Rampe wird der Winkel zwischen der Unterseite des Halbleiterchips und der Folie an der Ablösekante der Rampe vergrössert und dadurch die für das Ablösen der Folie vom Halbleiterchip nötige Kraft reduziert. Deshalb kann die Höhe der Ablösekante auf die angegebene Höhe von nur noch 0.3 bis 0.4 Millimeter reduziert werden. Neben der Ablösekante befindet sich eine mit Furchen versehene Stützfläche. Die Furchen verlaufen parallel zur Abziehrichtung bzw. orthogonal zur Ablösekante und sind mit Vakuum beaufschlagbar. Der Wafertisch ist in zwei orthogonalen Richtungen verschiebbar.

Das Ablösen der Halbleiterchips von der Folie und Aufnehmen mit dem Chipgreifer erfolgt wie folgt: Zunächst werden drei Verfahrensschritte durchgeführt, um den ersten abzulösenden Halbleiterchip bezüglich der Rampe auszurichten:
1. Verschieben des Wafertisches in der ersten Richtung, bis eine vordere Kante des ersten abzulösenden Halbleiterchips parallel und entlang der Ablösekante der Rampe verläuft,
2. Verschieben des Wafertisches in der zweiten Richtung, bis der erste abzulösende Halbleiterchip bezüglich der seitlichen Kanten der Rampe zentriert ist, und
3. Beaufschlagen der Furchen der Stützfläche mit Vakuum, so dass die Folie in diesem Bereich gegen die Stützfläche gezogen wird.
   Im nächsten Verfahrensschritt wird der erste Halbleiterchip von der Folie gelöst und für die Aufnahme mit dem Chipgreifer bereitgestellt.
4. Verschieben des Wafertisches in der ersten Richtung um eine vorbestimmte Distanz, die typischerweise etwa ein bis zwei Millimeter länger als die Länge des abzulösenden Halbleiterchips ist
   Bei diesem Verfahrensschritt wird die Folie über die Ablösekante der Rampe gezogen. Der Halbleiterchip wird mitbewegt. Dabei löst sich die Folie von der Unterseite des Halbleiterchips. Der von der Folie abgelöste Teil des Halbleiterchips hängt wie eine nur auf einer Seite abgestützte Platte schräg in der Luft. Wenn das hintere Ende des Halbleiterchips die Ablösekante der Rampe erreicht, dann fällt der Halbleiterchip auf die Folie zurück. Der Halbleiterchip befindet sich nun aber oberhalb der Stützfläche, wo die Folie in die Furchen der Stützfläche gezogen ist. Die Haftung des Halbleiterchips auf der Folie ist dadurch stark reduziert.
   Da die Länge des Vorschubs etwa ein bis zwei Millimeter länger als die Länge des abgelösten Halbleiterchips war, ragt der zweite abzulösende Halbleiterchip bereits über die Ablösekante der Rampe hinaus.
   Der erste abgelöste Halbleiterchip liegt nun auf der Stützfläche bereit für die Aufnahme durch den Chipgreifer. Die Lage und Orientierung dieses Halbleiterchips werden nun mittels einer Kamera vermessen. Sofern die Abweichung der gemessenen Ist-Lage von der Soll-Lage eine vorbestimmte Toleranzgrenze überschreitet, wird der Wafertisch verschoben, bis die Abweichung der Ist-Lage des Halbleiterchips von der Soll-Lage innerhalb der vorbestimmten Toleranzgrenze liegt. Dieser Verfahrensschritt hat mit dem eigentlichen Ablöseprozess von der Folie nichts zu tun. Die Einrichtung ist nun bereit, dass der Chipgreifer den ersten Halbleiterchip von der Folie aufnehmen und auf dem Substrat platzieren kann. Im nächsten Verfahrensschritt erfolgt also die Aufnahme des Halbleiterchips durch den Chipgreifer, beispielsweise so:
5. Absenken des Chipgreifers auf den auf der Stützfläche bereitliegenden Halbleiterchip, Beaufschlagen des Chipgreifers mit Vakuum und mit einer vorbestimmten Pickkraft und Abheben des Chipgreifers.

Da der Abstand zwischen den Halbleiterchips sehr gering ist, ist es unter Umständen erforderlich oder sinnvoll, die Rampe vor dem Verfahrensschritt 5 abzusenken, damit der Chipgreifer den Halbleiterchip aufnehmen kann, ohne dass der nächste Halbleiterchip vom Chipgreifer berührt wird.

Da nun der Chipgreifer den Halbleiterchip aufgenommen hat, kann der nächste Halbleiterchip von der Folie gelöst und auf der Stützfläche für die Aufnahme durch den Chipgreifer bereitgestellt werden. Der Wafertisch wird deshalb um die Länge der Halbleiterchips und die mittlere Breite der Sägespuren in der ersten Richtung verschoben.

Die auf der Folie vorhandenen Halbleiterchips werden Reihe um Reihe abgearbeitet, wobei jeweils der erste Halbleiterchip einer Reihe entsprechend den Verfahrensschritten 1 und 2 bezüglich der Rampe ausgerichtet wird.

Das Verfahren zum Picken eines dünnen Halbleiterchips von einer Folie kennzeichnet sich also dadurch aus, dass das Ablösen des Halbleiterchips von der Folie und das Aufnehmen des Halbleiterchips durch den Chipgreifer in zwei voneinander unabhängigen, aufeinanderfolgenden Verfahrensschritten erfolgt. Nach dem Ablösen landet der Halbleiterchip zwar nochmals auf der Folie. Weil aber der grosse Teil der Folie in die Furchen der Stützfläche hineingezogen ist, ist die Kontaktfläche zwischen der Folie und dem Halbleiterchip markant reduziert. Dementsprechend ist auch die Haftung des Halbleiterchips auf der Folie reduziert und der Halbleiterchip kann vom Chipgreifer problemlos aufgenommen werden.

Die Rampe mit der Ablösekante ist bevorzugt mit Ultraschall beaufschlagbar, damit der Ablöseprozess durch Ultraschall unterstützt werden kann. Des weiteren ist die Höhe der Ablösekante mit Vorteil einstellbar, damit die Höhe reduziert werden kann unmittelbar bevor der Halbleiterchip vollständig von der Folie gelöst ist.

Die Erfindung bietet mehrere Vorteile:
- Da der Höhenunterschied an der Ablösekante der Rampe mit typischerweise 0.3 Millimetern, höchstens 0.4 Millimetern, sehr gering ist, werden benachbarte Halbleiterchips nicht beschädigt, selbst wenn ihr Rand ebenfalls über die Rampe bewegt wird.
- Da der Chipgreifer das Ablösen des Halbleiterchips von der Folie nicht unterstützen muss, ist die für einen Bondzyklus benötigte Zeit unabhängig vom Ablöseprozess.
- Da die Stützfläche mit den Furchen benachbarte Halbleiterchips nicht stört, kann die Stützfläche grossflächig ausgebildet sein, so dass sie sowohl für kleine als auch für grosse Halbleiterchips die gleiche sein kann.
- Die Breite der Rampe entspricht im Idealfall der Breite der Halbleiterchips. Die Rampe ist deshalb bevorzugt als auswechselbares Einlegeteil ausgebildet, das in eine mit Vakuum beaufschlagbare Ausnehmung des Chip-Auswerfers eingelegt wird.

Im Verfahrensschritt 4 wird der Wafertisch verschoben und somit relativ zum Chip-Auswerfer bewegt. Alternativ kann der Chip-Auswerfer verschoben werden, da es nur auf eine Relativbewegung zwischen dem Wafertisch und dem Chip-Auswerfer ankommt.

Das beschriebene Verfahren funktioniert einwandfrei für eine Vielzahl von Folientypen und Klebstoffbeschichtungen des Wafers. Es gibt nun aber Klebstoffe, die beim Zersägen des Wafers in die Halbleiterchips durch die beim Sägen entstehende Hitze lokal flüssig werden. Dies führt dazu, dass sich der Klebstoff im Bereich der Kanten der Halbleiterchips mit der Folie verbindet und/oder benachbarte Halbleiterchips weiterhin durch Klebstoff miteinander verbunden sind (d.h. dass die Trennung der Klebstoffschicht zwischen den Halbleiterchips nicht vollständig ist). Andererseits gibt es Folien, die sehr elastisch sind. Wenn die Folie auf der Stützfläche mit Vakuum fixiert ist, dann wird die Folie beim Verschieben des Wafertisches nicht über die Rampe gezogen, sondern sie verzieht sich. Zur Lösung dieser Probleme schlägt die Erfindung besondere Massnahmen vor, die nun erläutert werden.

Eine Massnahme, um das Ablösen des Halbleiterchips von der Folie zu unterstützen, besteht darin, den Chip-Auswerfer mit heb- und senkbaren Nadeln auszurüsten. Die Nadeln sind beispielsweise in einem Nadelblock angeordnet. Die Nadeln sind vorzugsweise mit abgerundeten Köpfen ausgebildet, damit sie die Folie nicht durchstossen. Der oben erläuterte Verfahrensschritt 5 wird ersetzt durch den folgenden Verfahrensschritt 5A.

### 5A. Absenken des Chipgreifers auf den oder in kleinem Abstand über den auf der Stützfläche bereitliegenden Halbleiterchip, Anheben des Nadelblocks mit den Nadeln, bis die Nadeln die Folie gegen den Halbleiterchip drücken, und anschliessend gleichzeitiges Anheben des Nadelblocks und des Chipgreifers.

Dabei löst sich die Folie zunehmend von der Unterseite des Halbleiterchips, da sie vom Vakuum in die Furchen der Stützfläche hineingezogen wird, bis die Folie mit Ausnahme von Folienstücken zwischen den Köpfen der Nadeln und dem Halbleiterchip vom Halbleiterchip gelöst ist.

Der Verfahrensschritt 5A kann an sich wie im Stand der Technik üblich durchgeführt werden, vorzugsweise nach der in der europäischen Patentanmeldung EP 1424722 beschriebenen Methode, auf die hier explizit verwiesen wird.

Es gibt auch Anwendungen, bei denen es vorteilhaft ist, die Folie nicht von der ganzen Unterseite des Halbleiterchips abzuziehen, sondern beispielsweise nur von 90% der Unterseite. Dazu wird die Rampe abgesenkt, sobald die Folie um 90% abgezogen wurde. Der Wafertisch wird nun bei abgesenkter Rampe weiter verschoben, bis die vordere Kante des nächsten Halbleiterchips die Ablösekante der Rampe erreicht hat. Nun wird die Rampe wieder angehoben und der Wafertisch weiter verschoben, bis der abzulösende Halbleiterchip seine Sollposition über der Stützfläche erreicht hat. Dabei wird die Folie ordnungsgemäss vom nächsten Halbleiterchip abgezogen. Das Aufnehmen des Halbleiterchips von der Stützfläche erfolgt mit Unterstützung der Nadeln.

Eine Massnahme, um das Verziehen der Folie zu vermeiden, besteht darin, die Folie in kleinen Schritten abzuziehen, ohne dass die Stützfläche mit Vakuum beaufschlagt ist. Dazu wird wiederholt das Vakuum an der Stützfläche aufgehoben, der Wafertisch um einen Bruchteil der Länge des Halbleiterchips verschoben und dann Vakuum an die Stützfläche angelegt. Die Folie wird so stückweise jeweils auf der neu vorgeschobenen Länge des Halbleiterchips abgezogen.

Die Erfindung wird nachfolgend anhand eines Ausführungsbeispiels und anhand der Zeichnung näher erläutert.

Es zeigen:
- Fig. 1: eine Einrichtung zur Montage von Halbleiterchips mit einem erfindungsgemässen Chip-Auswerfer,
- Fig. 2: den Chip-Auswerfer in Aufsicht,
- Fig. 3: den Chip-Auswerfer in einem Schnitt entlang der Linie I-I der Fig. 2,
- Fig. 4-9: aufeinanderfolgende Momentaufnahmen während des Ablösens des Halbleiterchips von einer Folie und der Aufnahme des abgelösten Halbleiterchips mittels eines Chipgreifers gemäss einem ersten Verfahren,
- Fig. 10: ein weiteres Beispiel des Chip-Auswerfers,
- Fig. 11: einen Chip-Auswerfer mit einem Nadelblock,
- Fig. 12, 13: die Aufnahme des Halbleiterchips mit Unterstützung von Nadeln, und
- Fig. 14-17: Momentaufnahmen während des Ablösens des Halbleiterchips gemäss weiteren Verfahren.

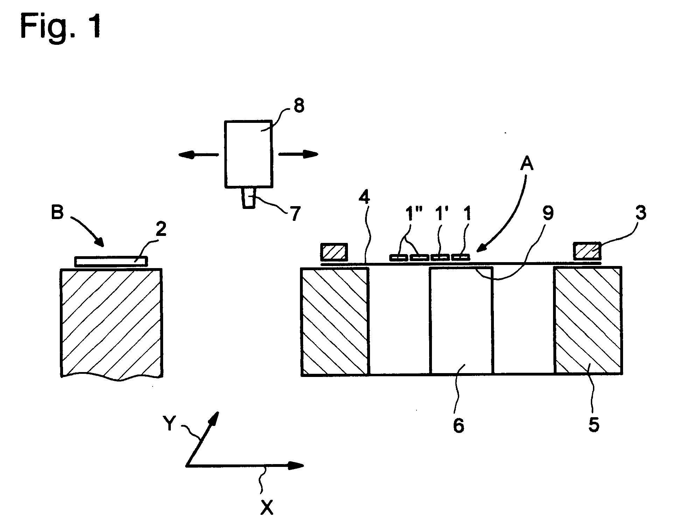

Die Fig. 1 zeigt in vereinfachter, schematischer Darstellung eine Einrichtung zur Montage von Halbleiterchips 1, 1', 1" auf einem Substrat 2. Die in Reihen und Kolonnen angeordneten Halbleiterchips 1, 1', 1" haften auf einer z.B. von einem Rahmen 3 gehaltenen Folie 4. Die Einrichtung weist einen verschiebbaren Wafertisch 5 auf, der den Rahmen 3 aufnimmt und einen Halbleiterchip 1 nach dem anderen an einem ersten Ort A bereitstellt. Am ersten Ort A ist unterhalb der Folie 4 ein erfindunggemässer, bei diesem Beispiel nadelloser Chip-Auswerfer 6 angeordnet. Der Chip-Auswerfer 6 dient dazu, bei der Entnahme des Halbleiterchips 1 dessen Ablösung von der Folie 4 zu unterstützen. Der Wafertisch 5 ist in zwei orthogonalen Richtungen x und y verschiebbar. Die Folie 4 ist so angeordnet, dass die Kanten der Halbleiterchips 1, 1', 1"' etwa parallel zu den Richtungen x bzw. y sind. Die Einrichtung weist weiter einen Chipgreifer 7 zum Transport des am ersten Ort A bereitgestellten Halbleiterchips 1 zu einem auf dem Substrat 2 befindlichen zweiten Ort B auf. Der Chipgreifer 7 ist Bestandteil eines heb- und senkbaren Bondkopfes 8. Der Bondkopf 8 und der Chipgreifer 7 werden zusammen zwischen dem Ort A und dem Ort B (oder mehreren Orten B₁, B₂, etc.) hin und her bewegt.

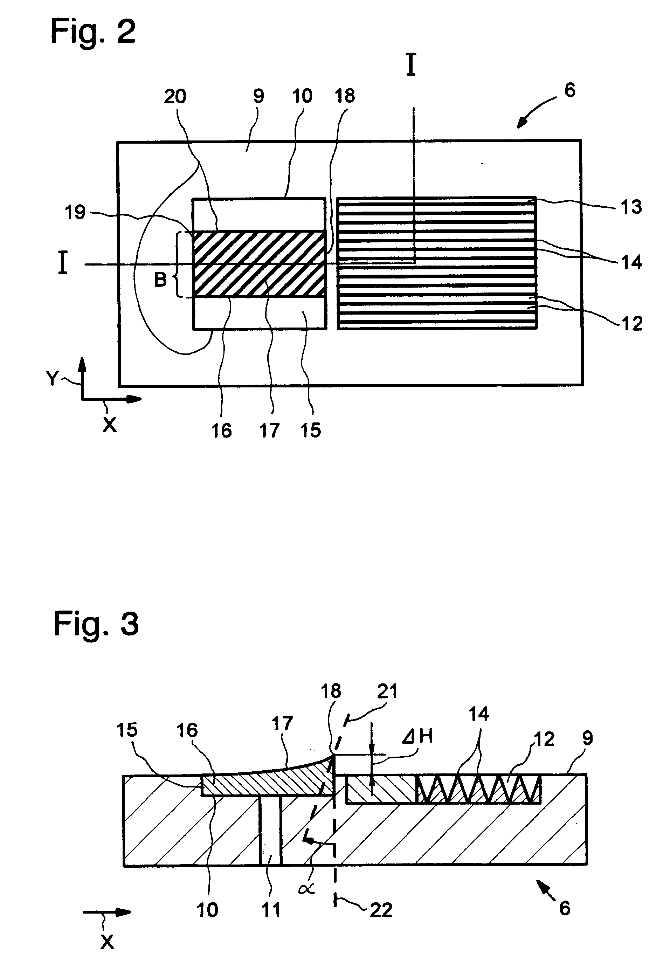

Die Fig. 2 zeigt den Chip-Auswerfer 6 in Aufsicht, d.h. die der Folie 4 zugewandte Oberfläche 9 des Chip-Auswerfers 6. Die Fig. 3 zeigt den Chip-Auswerfer 6 in einem Schnitt entlang der Linie I-I der Fig. 2. Die Oberfläche 9 des Chip-Auswerfers 6 enthält eine Vertiefung 10, in die eine mit Vakuum beaufschlagbare Bohrung 11 mündet, und eine mit parallel angeordneten Furchen 12 versehene Stützfläche 13. Die Furchen 12 verlaufen in x-Richtung und die Spitzen 14 der Furchen 12 sind bündig mit der Oberfläche 9 des Chip-Auswerfers 6. Der Abstand zwischen den Furchen 12 ist einerseits so gross, dass die Folie 4 in die Furchen 12 hineingezogen wird, wenn die Furchen 12 mit Vakuum beaufschlagt sind, und andererseits so klein, dass ein benachbarter Halbleiterchip, der mindestens teilweise auf der Stützfläche 13 liegt, nicht beschädigt wird, da die Folie 4 nicht in die Furchen 12 hinein gezogen wird, wenn die Folie 4 nicht vorgängig vom Halbleiterchip gelöst wurde. In die Vertiefung 10 ist passgenau ein Einlegeteil 15 eingelegt, das eine Rampe 16 mit einer konkaven Oberfläche 17 enthält. Die eine Seite der Rampe 16 bildet eine hervorstehende Ablösekante 18, an der die Folie 4 vom Halbleiterchip 1 abgelöst wird. Die gegenüberliegende Seite 19 der Rampe 16 ist bündig mit der Oberfläche 9 des Chip-Auswerfers 6. Bevorzugt ist die konkave Oberfläche 17 die Oberfläche eines Zylinders, dessen Längsachse parallel zur Ablösekante 18 verläuft und der beispielsweise einen Radius von 8 Millimetern hat. Die Breite B der Rampe 16 entspricht etwa der Breite der abzulösenden Halbleiterchips. Der Höhenunterschied AH zwischen der Ablösekante 18 und der Stützfläche 13 beträgt etwa 0.3 Millimeter. Wichtig ist, dass die Ablösekante 18 einen abrupten Übergang bildet, dem sich die Halbleiterchips beim Vorschub des Wafertisches 5 in x-Richtung nicht anzupassen vermögen. Die Ablösekante 18 verläuft parallel zur y-Richtung. Der Ort A (Fig. 1) befindet sich im Zentrum der Stützfläche 13.

Die Ausbildung der Oberfläche 17 der Rampe 16 als konkave Fläche bewirkt, dass der Winkel α, den die an die konkave Fläche an der Ablösekante 18 angelegte Tangente 21 und die Vertikale 22 einschliessen, deutlich kleiner als 90° gewählt werden kann. Je spitzer der Winkel α ist, desto besser löst sich die Folie 4 vom Halbleiterchip 1.

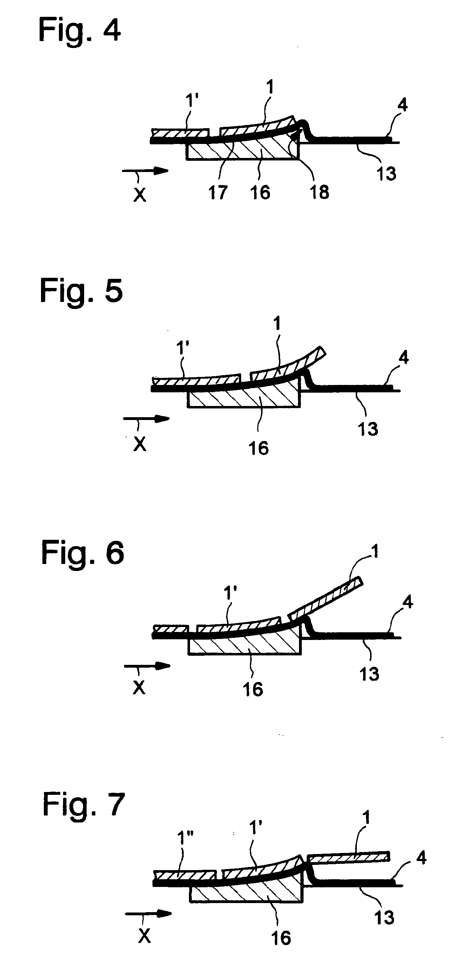

Das Ablösen des Halbleiterchips 1 von der Folie 4 erfolgt gemäss den weiter oben beschriebenen Verfahrensschritten. Die Fig. 4 bis 9 zeigen aufeinanderfolgende Momentaufnahmen während des Ablöseprozesses und des anschliessenden Pickprozesses. Die Fig. 4 bis 9 zeigen nur die für das Verständnis der Erfindung nötigen Elemente, nämlich die Rampe 16 und die Stützfläche 13, sowie die Folie 4 und nacheinander abzulösende Halbleiterchips 1, 1' und 1" einer gleichen Reihe des Wafers.

Gemäss den Verfahrensschritten 1 bis 3 wird der Wafertisch so positioniert, dass eine vordere Kante des ersten abzulösenden Halbleiterchips 1 einer Reihe des Wafers parallel und entlang der Ablösekante 18 der Rampe 16 verläuft und dass der erste abzulösende Halbleiterchip 1 dieser Reihe bezüglich der seitlichen Kanten 20 (Fig. 2) der Rampe 16 zentriert ist. Zudem werden die Furchen 12 der Stützfläche 13 mit Vakuum beaufschlagt, so dass die Folie 4 in diesem Bereich in die Furchen 12 gezogen wird. Diesen Zustand zeigt die Fig. 4. Der Wafertisch 5 wird nun in der x-Richtung um eine vorbestimmte Distanz ΔL vorgeschoben. Die Folie 4 wird dabei über die Ablösekante 18 der Rampe 16 gezogen. Der Halbleiterchip 1 wird mitbewegt. Die Fig. 5 bis 8 zeigen aufeinanderfolgende Momentaufnahmen während dieses Vorschubs. Wegen des spitzen Winkels α, der die Geometrie der Ablösekante 18 charakterisiert, löst sich der Halbleiterchip 1 von der Folie 4 und der abgelöste Teil steht schräg in der Luft (Fig. 5, 6). Sobald das hintere Ende des Halbleiterchips 1 die Ablösekante 18 (Fig. 7) erreicht, dreht sich der Halbleiterchip 1 infolge der Schwerkraft um seine hintere Kante und fällt auf die Folie 4 über der Stützfläche 13.

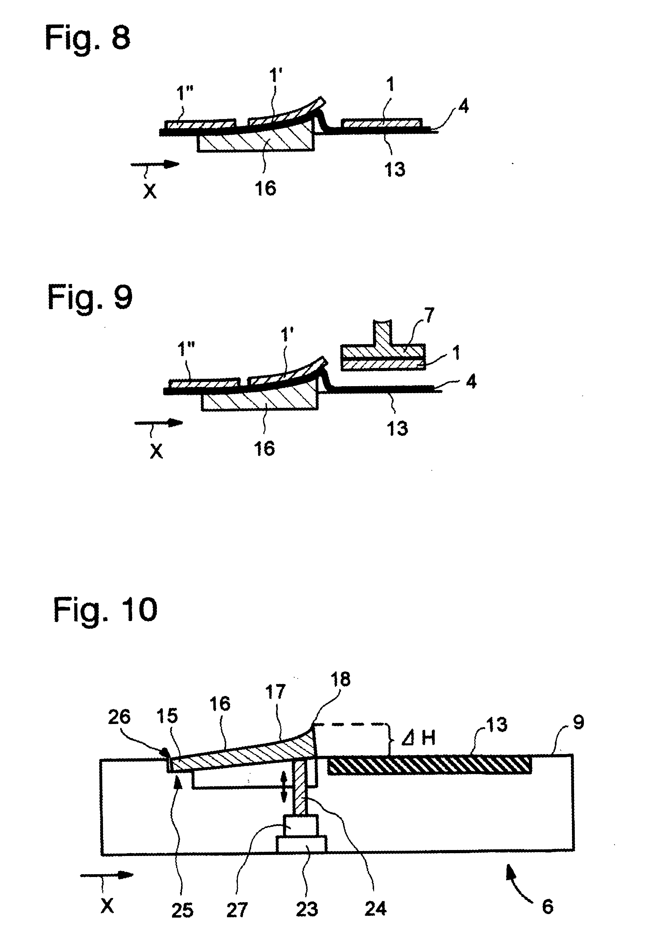

Da die Länge des Vorschubs etwa ein bis zwei Millimeter länger als die Länge des abgelösten Halbleiterchips 1 war, ragt der nächste abzulösende Halbleiterchip 1' bereits über die Ablösekante 18 der Rampe 16 hinaus. Diesen Zustand zeigt die Fig. 8.

Der erste abgelöste Halbleiterchip 1 liegt nun auf Folie 4 oberhalb der Stützfläche 13 bereit für die Aufnahme durch den Chipgreifer 7. Die Lage und Orientierung dieses Halbleiterchips 1 werden nun mittels einer Kamera vermessen. Sofern die Abweichung der gemessenen Ist-Lage von der Soll-Lage eine vorbestimmte Toleranzgrenze überschreitet, wird der Wafertisch 5 verschoben, bis die Abweichung der Ist-Lage des Halbleiterchips 1 von der Soll-Lage innerhalb der vorbestimmten Toleranzgrenze liegt. Dieser Verfahrensschritt hat mit dem eigentlichen Ablöseprozess von der Folie nichts zu tun. Die Einrichtung ist nun bereit, dass der Chipgreifer 7 den ersten Halbleiterchip 1 von der Folie 4 aufnehmen und auf dem Substrat 2 (Fig. 1) platzieren kann. Die Fig. 9 zeigt den Zustand unmittelbar nach der Aufnahme des Halbleiterchips 1 durch den Chipgreifer 7.

Das beschriebene Ausführungsbeispiel ist so konzipiert, dass die Halbleiterchips 1 an einem festen Ort A für die Aufnahme durch den Chipgreifer 7 bereitgestellt werden. Die Montageeinrichtung kann aber auch so konzipiert sein, dass die Halbleiterchips an verschiedenen Orten A₁, A₂, etc. bereitgestellt und vom Chipgreifer 7 aufgenommen werden. In diesem Fall ist es auch möglich, anstelle des Wafertisches 5 nur den Chip-Auswerfer 6 oder den Wafertisch 5 und den Chip-Auswerfer 6 auf geeignete Weise zu verschieben, um die Folie 4 an der Ablösekante 18 der Rampe 16 abzulösen, da es zum Ablösen der Folie 4 nur auf eine Relativbewegung zwischen dem Wafertisch 5 und der Ablösekante 18 der Rampe 16 ankommt.

Die Fig. 10 zeigt ein weiteres Ausführungsbeispiel des Chip-Auswerfers 6, bei dem die Höhendifferenz ΔH zwischen der Ablösekante 18 und der Stützfläche 13 mittels eines von einem Antrieb 23 auf und ab bewegbaren Kolbens 24 einstellbar ist. Der Kolben 24 ist in der Nähe der Ablösekante 18 angeordnet, damit die Rampe 16 beim Anheben des Kolbens 24 um die der Ablösekante 18 diagonal gegenüberliegende Kante 25 gedreht wird, so dass die der Ablösekante 18 gegenüberliegende Kante 26 der Rampe 16 bündig mit der Oberfläche 9 des Chip-Auswerfers 6 bleibt. Diese Ausführung ermöglicht eine optimale Anpassung der Höhendifferenz ΔH an die Eigenschaften der Folie. Zudem ermöglicht diese Ausführung eine Verfeinerung des Ablöseverfahrens, indem im Verfahrensschritt 4 die Höhendifferenz ΔH am Anfang einen vorbestimmten Wert ΔH₁ aufweist, bis der in der Fig. 6 dargestellte Zustand erreicht ist. Nun wird der Kolben 24 abgesenkt, so dass die Höhendifferenz ΔH einen kleineren Wert ΔH₂ aufweist. Die Höhendifferenz ΔH₂ wird mindestens solange beibehalten, bis der in der Fig. 7 dargestellte Zustand erreicht ist, wo sich der Halbleiterchip 1 infolge der Schwerkraft um seine hintere Kante dreht, wobei er vollständig von der Folie 4 gelöst ist und infolge der Schwerkraft auf die Stützfläche 13 fällt. Anschliessend wird der Kolben 24 wieder angehoben, so dass die Höhendifferenz ΔH wieder den Wert ΔH₁ aufweist. Der Wert ΔH₂ kann auch Null sein.

Des weiteren ist das Einlegeteil 15 bevorzugt direkt oder gegebenenfalls über den Kolben 24 mit einem Ultraschallgeber 27 gekoppelt, damit der Ablöseprozess mit Ultraschall unterstützt werden kann. Möglich ist auch eine Konstruktion, bei der der ganze Chip-Auswerfer 6 mit Ultraschall beaufschlagt wird.

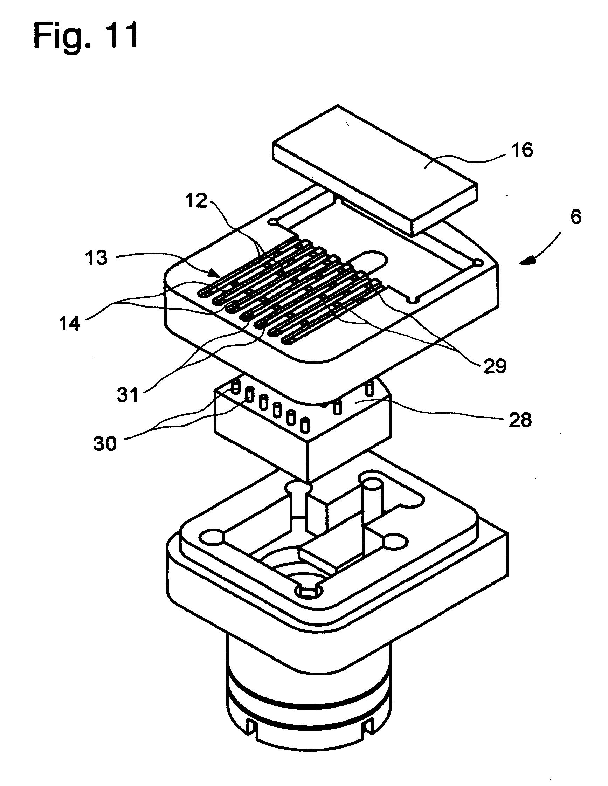

Die Fig. 11 zeigt in Explosionsansicht ein Ausführungsbeispiel des Chip-Auswerfers 6 mit einem Nadelblock 28. Die Spitzen 14 zwischen den Furchen 12 enthalten Löcher 29, durch die die Nadeln 30 des Nadelblocks 28 jeweils hindurchstossen. Die Furchen 12 enthalten ebenfalls Löcher 31, die mit Vakuum beaufschlagbar sind. Im zusammengebauten Zustand sind der Nadelblock 28 und die Rampe 16 heb- und senkbar.

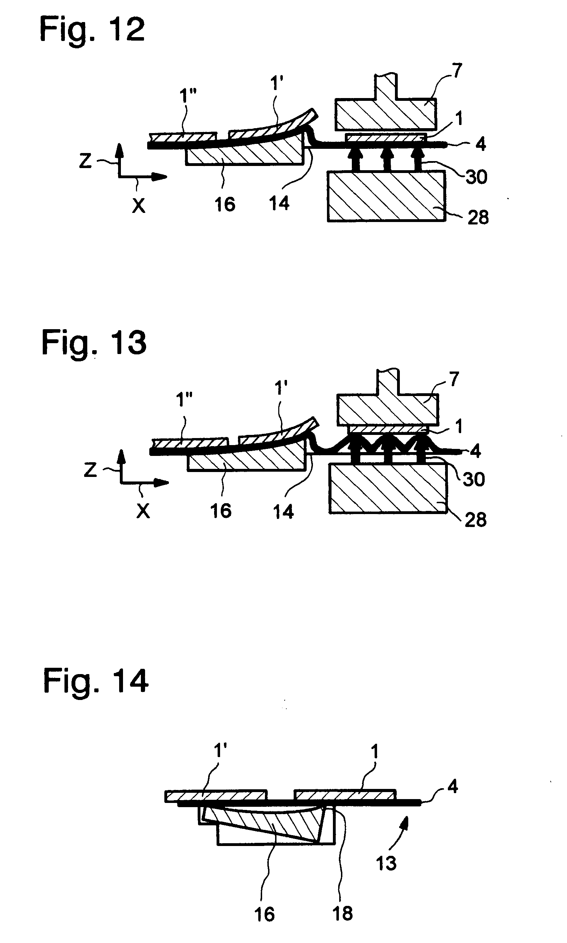

Die Fig. 12 und 13 zeigen den Einsatz der Nadeln 30 im Grundsatz, ohne Details. Der Halbleiterchip 1 liegt auf der Folie 4 oberhalb der Stützfläche 13 des Chip-Auswerfers 6. Der Chipgreifer 7 ist bereit um den Halbleiterchip 1 aufzunehmen. Der Nadelblock 28 wird in z-Richtung angehoben, so dass die Nadeln 30 die Folie 4 lokal anheben, ohne sie zu durchstossen. Dieser Zustand ist in der Fig. 12 gezeigt. Sobald die gewünschte Pickkraft erreicht ist, werden der Chipgreifer 7 und der Nadelblock 28 gemeinsam weiter angehoben. Dabei löst sich die Folie 4 weitgehend von der Unterseite des Halbleiterchips 1, da das Vakuum die Folie 4 zwischen den Nadeln 30 in die Furchen 12 hinabzieht. Schliesslich wird die Bewegung des Nadelblocks 28 gestoppt. Dieser Zustand ist in der Fig. 13 gezeigt. Wenn der Chipgreifer 7 weiter angehoben wird, dann löst sich der Halbleiterchip 1 endgültig von der Folie 4. Bei diesem Beispiel sind die Spitzen der Nadeln 30 nicht spitzig sondern rund, derart, dass sie die Folie 4 nicht durchstossen.

Der Nadelblock 28 kann an sich wie im Stand der Technik üblich eingesetzt werden. Bevorzugt wird die in der europäischen Patentanmeldung EP 1424722 beschriebene Methode angewendet.

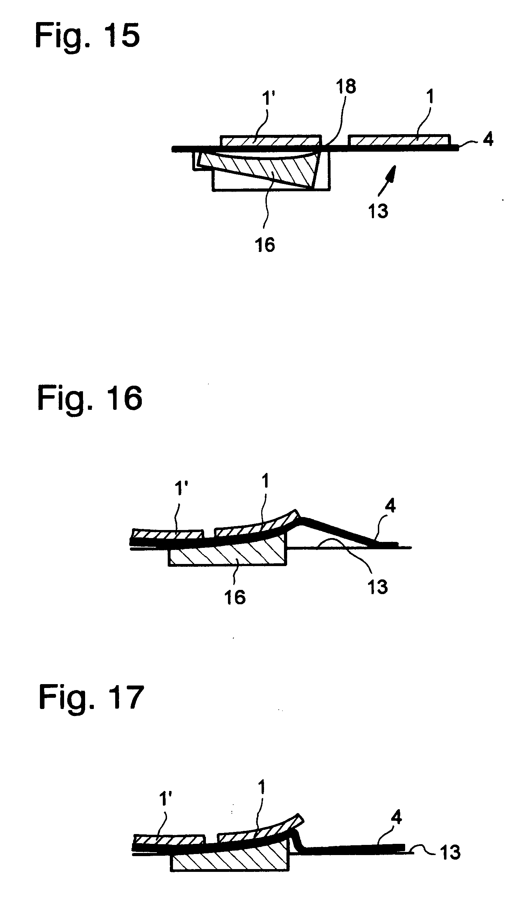

Das anhand der Fig. 4 bis 8 illustrierte Verfahren, bei dem die Folie 4 zu 100% von der Unterseite des Halbleiterchips 1 abgezogen wird, kann modifiziert werden, um die Folie 4 zu einem kleineren Prozentsatz, beispielsweise zu 80% oder 90%, von der Unterseite des Halbleiterchips 1 abzuziehen. Die Fig. 6 zeigt den Zustand, wo die Folie 4 auf einer Länge von etwa 80% des Halbleiterchips 1 abgezogen ist. Nachdem die Verfahrensschritte 1 bis 3 durchgeführt sind, wird im Verfahrensschritt 4A die Folie 4 nicht vollständig abgezogen, im Verfahrensschritt 4B die Rampe 16 abgesenkt, im Verfahrensschritt 4C der Wafertisch 5 weiter verschoben, bis der Halbleiterchip 1 die Sollposition über der Stützfläche 13 erreicht hat:
4A. Verschieben des Wafertisches 5 in der ersten Richtung um eine vorbestimmte Distanz, die kürzer als die Länge des abzulösenden Halbleiterchips 1 ist.
4B. Absenken der Rampe 16, so dass die Ablösekante 18 nicht mehr über die Stützfläche 13 vorsteht. (Dieser Zustand ist in der Fig. 14 gezeigt.)
4C. Verschieben des Wafertisches 5 in der ersten Richtung, bis der nächste Halbleiterchip 1' die Ablösekante 18 der Rampe 16 erreicht hat. (Dieser Zustand ist in der Fig. 15 gezeigt.)
4D. Anheben der Rampe 16.
4E. Verschieben des Wafertisches 5 in der ersten Richtung, bis der Halbleiterchip 1 die Sollposition über der Stützfläche 13 erreicht hat. (Dieser Zustand ist in der Fig. 8 dargestellt.)

Anschliessend erfolgt die Aufnahme des Halbleiterchips 1 durch den Chipgreifer 7 mit Unterstützung der Nadeln 30.

Bei den bisher beschriebenen Beispielen werden die Furchen 12 in der Stützfläche 13 mit Vakuum beaufschlagt, während dem der Wafertisch 5 verschoben wird, um die Folie 4 abzuziehen. Dieses Verfahren eignet sich für Folien, die dabei über die Stützfläche 13 rutschen. Es gibt aber auch Folien, die dabei nicht über die Stützfläche 13 rutschen, sondern die sich verziehen. Für solche Folien entfällt der Verfahrensschritt 3 und der Verfahrensschritt 4 wird wie folgt modifiziert:
4AA. Verschieben des Wafertisches 5 in der ersten Richtung um eine vorbestimmte kurze Distanz.
   Weil an der Stützfläche 13 kein Vakuum anliegt, wird die Folie 4 nicht in die Furchen 12 der Stützfläche 13 hineingezogen und somit auch nicht von der Unterseite des Halbleiterchips 1 abgezogen. Die Fig. 16 zeigt den Zustand nach der erstmaligen Durchführung des Verfahrenschrittes 4AA.
4BB. Beaufschlagen der Stützfläche 13 mit Vakuum.
   Sobald die Stützfläche 13 mit Vakuum beaufschlagt wird, wird die Folie 4 in die Furchen 12 der Stützfläche 13 hineingezogen und somit von der über die Ablösekante 18 hervorstehende Unterseite des Halbleiterchips 1 abgezogen. Die Fig. 17 zeigt den Zustand nach der erstmaligen Durchführung des Verfahrenschrittes 4BB.
4CC. Lösen des Vakuums an der Stützfläche 13.
4DD. Wiederholen der Verfahrensschritte 4AA bis 4CC, bis die Folie 4 vollständig oder im gewünschten Ausmass vom Halbleiterchip 1 abgezogen ist.
4EE. Lösen des Vakuums an der Stützfläche 13 und Verschieben des Wafertisches 5 in der ersten Richtung, bis der nächste Halbleiterchip l' um die vorbestimmte kurze Distanz über die Ablösekante 18 der Rampe 16 hervorsteht und gegebenenfalls wiederholen der Schritte 4AA bis 4CC bis der Halbleiterchip 1 die Sollposition über der Stützfläche 13 erreicht hat.

## Patentansprüche

1. Verfahren zum Ablösen eines Halbleiterchips (1) von einer Folie (4) und Aufnehmen des Halbleiterchips (1) von der Folie (4) mit einem Chipgreifer (7), wobei die Folie (4) auf einem verschiebbaren Wafertisch (5) fixiert ist und ein Teil der Folie (4) auf einer Oberfläche (9) eines Chip-Auswerfers (6) aufliegt, **dadurch gekennzeichnet, dass** der Wafertisch (5) relativ zum Chip-Auswerfer (6) verschoben wird, um die Folie (4) über eine von der Oberfläche (9) des Chip-Auswerfers (6) hervorstehende Ablösekante (18) zu ziehen, wobei die Ablösekante (18) eine Rampe (16) begrenzt, deren Oberfläche (17) konkav ausgebildet ist, wobei sich der Halbleiterchip (1) vorübergehend mindestens teilweise von der Folie (4) löst und auf der Folie (4) oberhalb einer Stützfläche (13) landet, die mit Vakuum beaufschlagbare Furchen (12) aufweist, und dass der Chipgreifer (7) den auf der Stützfläche (13) bereitliegenden Halbleiterchip (1) aufnimmt.

2. Verfahren nach Anspruch 1, **dadurch gekennzeichnet, dass** die Furchen (12) der Stützfläche (13) während der Relativverschiebung von Wafertisch (5) und Chip-Auswerfer (6) mit Vakuum beaufschlagt sind.

3. Verfahren nach Anspruch 2, **dadurch gekennzeichnet, dass** die Höhe der Ablösekante (18) relativ zur Oberfläche (9) reduziert wird, bevor die Folie (4) vollständig vom Halbleiterchip (1) gelöst ist.

4. Verfahren nach Anspruch 1, **dadurch gekennzeichnet, dass** abwechslungsweise der Wafertisch (5) relativ zum Chip-Auswerfer (6) verschoben wird, ohne dass die Furchen (12) der Stützfläche (13) mit Vakuum beaufschlagt sind, und die Furchen (12) der Stützfläche (13) mit Vakuum beaufschlagt werden, während der Wafertisch (5) stillsteht, wobei der Wafertisch (5) jeweils um einen Bruchteil der Länge des Halbleiterchips (1) verschoben wird, und dass diese Schritte mehrfach wiederholt werden.

5. Verfahren nach einem der Ansprüche 1 bis 4, **dadurch gekennzeichnet, dass** die Ablösung des Halbleiterchips (1) mit Ultraschall unterstützt wird.

6. Einrichtung für die Montage von Halbleiterchips, die auf einer Folie (4) haften, mit einem verschiebbaren Wafertisch (5) für die Aufnahme der Folie (4), mit einem Chip-Auswerfer (6) und mit einem Chipgreifer (7) für das Aufnehmen eines Halbleiterchips (1) von der Folie (4) und Platzieren des Halbleiterchips (1) auf einem Substrat (2), **dadurch gekennzeichnet, dass** der Chip-Auswerfer (6) eine Rampe (16), deren Oberfläche (17) konkav ausgebildet ist und an einer von der Oberfläche (9) des Chip-Auswerfers (6) hervorstehenden Ablösekante (18) endet, und eine neben der Ablösekante (18) angeordnete Stützfläche (13) mit Furchen (12), die mit Vakuum beaufschlagbar sind, aufweist und dass der Chipgreifer (7) den auf der Stützfläche (13) bereitgestellten Halbleiterchip (1) aufnimmt.

7. Einrichtung nach Anspruch 6, **dadurch gekennzeichnet, dass** die Ablösekante (18) um höchstens 0.4 Millimeter von der Oberfläche (9) des Chip-Auswerfers (6) hervorsteht.

8. Einrichtung nach Anspruch 6 oder 7, **dadurch gekennzeichnet, dass** die Furchen (12) orthogonal zur Ablösekante (18) verlaufen.

9. Einrichtung nach einem der Ansprüche 6 bis 8, **dadurch gekennzeichnet, dass** die konkave Oberfläche (17) der Rampe (16) die Oberfläche eines Zylinders ist, dessen Längsachse parallel zur Ablösekante (18) verläuft.

10. Einrichtung nach einem der Ansprüche 6 bis 9, **dadurch gekennzeichnet, dass** die Höhe der Ablösekante (18) verstellbar ist.

11. Einrichtung nach einem der Ansprüche 6 bis 10, **dadurch gekennzeichnet, dass** die Rampe (16) mit Ultraschall beaufschlagbar ist.

## Claims

1. Method for detaching a semiconductor chip (1) from a foil (4) and picking the semiconductor chip (1) from the foil (4) with a chip gripper (7), whereby the foil (4) is fixed on a movable wafer table (5) and part of the foil (4) rests on a surface (9) of a chip ejector (6), **characterised in that** the wafer table (5) is shifted relative to the chip ejector (6) in order to pull the foil (4) over a stripping edge (18) protruding above the surface (9) of the chip ejector (6), whereby the stripping edge (18) borders a ramp (16), the surface (17) of which is formed concave, whereby the semiconductor chip (1) temporarily detaches itself at least partly from the foil (4) and lands on the foil (4) above a support area (13) that has grooves (12) to which vacuum can be applied, and that the chip gripper (7) picks up the semiconductor chip (1) presented on the support area (13).

2. Method according to claim 1, **characterised in that** vacuum is applied to the grooves (12) of the support area (13) during the relative shifting of wafer table (5) and chip ejector (6).

3. Method according to claim 2, **characterised in that** the height of the stripping edge (18) relative to the surface (9) is reduced before the foil (4) is completely detached from the semiconductor chip (1).

4. Method according to claim 1, **characterised in that** alternately the wafer table (5) is shifted relative to the chip ejector (6) without vacuum being applied to the grooves (12) of the support area (13), and vacuum is applied to the grooves (12) of the support area (13) while the wafer table (5) is stationary, whereby the wafer table (5) is shifted each time by a fraction of the length of the semiconductor chip (1), and that these steps are repeated several times.

5. Method according to one of claims 1 to 4, **characterised in that** detachment of the semiconductor chip (1) is supported by ultrasound.

6. Apparatus for mounting semiconductor chips that adhere to a foil (4) with a movable wafer table (5) for accommodating the foil (4), with a chip ejector (6) and with a chip gripper (7) for picking a semiconductor chip (1) from the foil (4) and placing the semiconductor chip (1) onto a substrate (2), **characterised in that** the chip ejector (6) has a ramp (16), the surface (17) of which is formed concave and ends at a stripping edge (18) protruding from the surface (9) of the chip ejector (6), and a support area (13) arranged next to the stripping edge (18) with grooves (12) to which vacuum can be applied, and that the chip gripper (7) picks the semiconductor chip (1) presented on the support area (13).

7. Apparatus according to claim 6, **characterised in that** the stripping edge (18) protrudes by maximum 0.4 millimetres from the surface (9) of the chip ejector (6).

8. Apparatus according to claim 6 or 7, **characterised in that** the grooves (12) run orthogonally to the stripping edge (18).

9. Apparatus according to one of claims 6 to 8, **characterised in that** the concave surface (17) of the ramp (16) is the surface of a cylinder the longitudinal axis of which runs parallel to the stripping edge (18).

10. Apparatus according to one of claims 6 to 9, **characterised in that** the height of the stripping edge (18) is adjustable.

11. Apparatus according to one of claims 6 to 10, **characterised in that** ultrasound can be applied to the ramp (16).

## Revendications

1. Procédé pour détacher une puce à semi-conducteurs (1) d'une feuille (4) et prélèvement de la puce à semi-conducteurs (1) depuis la feuille (4) avec un préhenseur de puces (7), dans lequel la feuille (4) est fixée sur une table déplaçable pour plaquette de matériau semi-conducteur (5) et dans lequel une partie de la feuille (4) est posée sur une surface (9) d'un éjecteur de puces (6), **caractérisé en ce que** la table pour plaquette de matériau semi-conducteur (5) est déplacée par rapport à l'éjecteur de puces (6) pour tirer la feuille (4) par l'intermédiaire d'une arête de détachement (18) faisant saillie de la surface (9) de l'éjecteur de puces (6), sachant que l'arête de détachement (18) limite une rampe (16) dont la surface (17) est réalisée de manière concave, que la puce à semi-conducteurs (1) se détache temporairement au moins en partie de la feuille (4) et atterrit sur la feuille (4) au-dessus d'une surface de support (13) qui présente des rainures (12) pouvant être soumises à un vide, et **en ce que** le préhenseur de puces (7) prélève la puce à semi-conducteurs (1) se trouvant à disposition sur la surface de support (13).

2. Procédé selon la revendication 1, **caractérisé en ce que** les rainures (12) de la surface de support (13) peuvent être soumises à un vide pendant le déplacement relatif de la table pour plaquette de matériau semi-conducteur (5) et de l'éjecteur de puces (6).

3. Procédé selon la revendication 2, **caractérisé en ce que** la hauteur de l'arête de détachement (18) est réduite par rapport à la surface (9) avant que la feuille (4) soit entièrement détachée de la puce à semi-conducteurs (1).

4. Procédé selon la revendication **1, caractérisé en ce que** la table pour plaquette de matériau semi-conducteur (5) est déplacée en alternance par rapport à l'éjecteur de puces (6) sans que les rainures (12) de la surface de support (13) soient soumises à un vide, et les rainures (12) de la surface de support (13) sont soumises à un vide pendant que la table pour plaquette de matériau semi-conducteur (5) est immobilisée, la table pour plaquette de matériau semi-conducteur (5) étant déplacée respectivement d'une fraction de la longueur de la puce à semi-conducteurs (1), et **en ce que** ces étapes sont répétées plusieurs fois.

5. Procédé selon l'une des revendications 1 à 4, **caractérisé en ce que** le détachement de la puce à semi-conducteurs (1) est soutenu par ultrasons.

6. Dispositif pour le montage de puces à semi-conducteurs qui adhèrent sur une feuille (4), comprenant : une table pour plaquette de matériau semi-conducteur mobile (5) afin de réceptionner la feuille (4), un éjecteur de puces (6) et un préhenseur de puces (7) pour prélever une puce à semi-conducteurs (1) depuis la feuille (4) et placer la puce à semi-conducteurs (1) sur un substrat (2), **caractérisé en ce que** l'éjecteur de puces (6) a une rampe (16) dont la surface (17) est réalisée de manière concave, et se termine sur une arête de détachement (18) faisant saillie de la surface (9) de l'éjecteur de puces (6), et présente une surface de support (13) agencée à côté de l'arête de détachement (18) et comportant des rainures (12) qui peuvent être soumises à un vide, et **en ce que** le préhenseur de puces (7) prélève la puce à semi-conducteurs (1) mise à disposition sur la surface de support (13).

7. Dispositif selon la revendication 6, **caractérisé en ce que** l'arête de détachement (18) dépasse au plus de 0,4 millimètre de la surface (9) de l'éjecteur de puces (6).

8. Dispositif selon l'une ou l'autre des revendications 6 et 7, **caractérisé en ce que** les rainures (12) s'étendent orthogonalement par rapport à l'arête de détachement (18).

9. Dispositif selon l'une des revendications 6 à 8, **caractérisé en ce que** la surface concave (17) de la rampe (16) est la surface d'un cylindre dont l'axe longitudinal s'étend parallèlement à l'arête de détachement (18).

10. Dispositif selon l'une des revendications 6 à 9, **caractérisé en ce que** la hauteur de l'arête de détachement (18) est réglable.

11. Dispositif selon l'une des revendications 6 à 10, **caractérisé en ce que** la rampe (16) peut être soumise à des ultrasons.
